(19) Europäisches Patentamt European Patent Office Office européen des brevets

(11) **EP 4 700 410 A1**

(12) **EUROPEAN PATENT APPLICATION**
published in accordance with Art. 153(4) EPC

(43) Date of publication:
**25.02.2026 Bulletin 2026/09**

(21) Application number: **24880009.6**

(22) Date of filing: **30.09.2024**

(51) International Patent Classification (IPC):
*G01R 31/389* (2019.01)    *G01R 23/02* (2006.01)
*G01R 23/00* (2006.01)    *G01R 31/371* (2019.01)
*G01R 31/367* (2019.01)

(52) Cooperative Patent Classification (CPC):
**G01R 23/00; G01R 23/02; G01R 31/367;**
**G01R 31/371; G01R 31/389**

(86) International application number:
**PCT/KR2024/014884**

(87) International publication number:
**WO 2025/084670 (24.04.2025 Gazette 2025/17)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **18.10.2023 KR 20230139551**

(71) Applicant: **LG Energy Solution, Ltd.**
**Seoul 07335 (KR)**

(72) Inventor: **KIM, Sangyeon**
**Daejeon 34122 (KR)**

(74) Representative: **Hoffmann Eitle**
**Patent- und Rechtsanwälte PartmbB**
**Arabellastraße 30**
**81925 München (DE)**

(54) **METHOD FOR MEASURING IMPEDANCE OF BATTERY CELL AND IMPEDANCE MEASUREMENT SYSTEM FOR PROVIDING SAME METHOD**

(57) The present disclosure relates to an impedance measurement method of a battery cell and an impedance measurement system providing the method. The impedance measurement system includes a user input/output unit that receives test input values including a start frequency, an end frequency, and the number of frequencies from a user, a user control unit that calculates a plurality of request frequencies corresponding to the number of frequencies based on the test input values, and matches a plurality of testable frequencies stored in a lookup table with the plurality of request frequencies to determine a plurality of test frequencies, and a user communication unit that transmits the plurality of test frequencies to a test apparatus that is an impedance measurement apparatus for a battery cell.

【FIG. 2】

S100a
INPUT, BY USER TERMINAL, INFORMATION ON START FREQUENCY, END FREQUENCY, AND NUMBER OF FREQUENCY FROM USER — S110a

DETERMINE, BY USER TERMINAL, PLURALITY OF TEST FREQUENCIES — S130a

TRANSMIT, BY CONVERSION DEVICE, PLURALITY OF TEST FREQUENCIES RECEIVED FROM USER TERMINAL TO TEST APPARATUS — S200a

MEASURE, BY TEST APPARATUS, IMPEDANCE OF BATTERY CELL BASED ON PLURALITY OF TEST FREQUENCIES — S300a

EP 4 700 410 A1

**Description**

**[Technical Field]**

CROSS-REFERENCE TO RELATED APPLICATION

This application claims priority to and the benefit of Korean Patent Application No. 10-2023-0139551 filed in the Korean Intellectual Property Office on October 18, 2023, the entire contents of which are incorporated herein by reference.

The present disclosure relates to an impedance measurement method of a battery cell and an impedance measurement system providing the method.

**[Background Art]**

Electrochemical impedance spectroscopy (EIS) is an experimental method capable of identifying internal electrical characteristics of an unknown sample other than an electrical circuit. In other words, the EIS may interpret electrical characteristics of a sample by being equated to a standard model such as an electronic circuit through impedance analysis.

Specifically, the EIS sequentially applies a sine wave waveform to the sample from high frequency to low frequency, measures changes in amplitude and phase according to the response sine wave coming through the sample, and then estimates an impedance. (i) Understand characteristics of R, L, and C according to a response waveform to the applied waveform in an electric circuit. (ii) Express a current response and phase characteristic changes according to the frequency of the impedance in a complex number system. (iii) Understand a Nyquist plot using a complex number expression. (iv) Understand an electrochemical sample using the Nyquist plot.

Meanwhile, the electrochemical sample may be composed of an electrochemical cell and an electrochemical electrode. The electrochemical cell has various types of resistors (R), capacitors (C), and inductors (L) in series and parallel depending on its structure, a type of electrodes, and a concentration and type of electrolyte. The electrochemical electrode may be mounted on various electrochemical cells depending on the experimental purpose as follows.

Parameter values of the components R, L, and C may change due to various structures, and various serial and parallel connection forms may occur. However, we may not visually determine and analyze its structure due to the characteristics of the electrochemical cell. Accordingly, the impedance of the electrochemical cell may be estimated to infer its structure and parameter values.

**[Disclosure]**

**[Technical Problem]**

The present disclosure attempts to provide an impedance measurement method of a battery cell based on the number of frequencies desired by a user without overlapping frequencies, and an impedance measurement system providing the method.

**[Technical Solution]**

According to an aspect of the present disclosure, an impedance measurement system includes: a user input/output unit that receives test input values including a start frequency, an end frequency, and the number of frequencies from a user; a user control unit that calculates a plurality of request frequencies corresponding to the number of frequencies based on the test input values, and matches a plurality of testable frequencies stored in a lookup table with the plurality of request frequencies to determine a plurality of test frequencies; and a user communication unit that transmits the plurality of test frequencies to a test apparatus that is an impedance measurement apparatus for a battery cell.

The user control unit may convert each of the start frequency and the end frequency into a common log to calculate a logic start frequency and a logic end frequency, divide the logic start frequency to the logic end frequency into equal intervals to calculate a plurality of logic equal interval frequencies corresponding to the number of frequencies, and inversely convert the plurality of logic equal interval frequencies into a common log to calculate the plurality of request frequencies.

The user control unit may determine, for each of the plurality of request frequencies, a first testable frequency corresponding to a size closest to a size of a first request frequency among the plurality of testable frequencies as a first test frequency corresponding to the first request frequency.

The user control unit may determine a second testable frequency corresponding to a size next closer to a size of a second request frequency as a second test frequency corresponding to the second request frequency when the size of the second request frequency among the plurality of testable frequencies is closest to the first testable frequency.

The user control unit may determine whether Equation (1) or Equation (2) is satisfied for each of the plurality of request frequencies, apply Equations (3) and (4) and then determine again whether Equations (1) and (2) are satisfied, when the determination result shows that neither Equation (1) nor Equation (2) is satisfied, and apply Equation (5) to determine the test frequency, when it is determined as the determination result when Equation (1) or Equation (2) is satisfied.

$$z \leq |\ A\ [x]\ -\ B\ [y]\ |\ \ -\text{Equation (1)}$$

$$y = n - 2 - \text{Equation (2)}$$

$$y = y + 1 - \text{Equation (3)}$$

$$z = |\ A\ [x]\ -\ B\ [y]\ |\ \ -\text{Equation (4)}$$

$$A\ [x]\ =\ C\ [x]\ =\ B\ [y\text{-}1]\ \ -\text{Equation (5)}$$

Here, variable x may be a natural number as a request frequency number, variable y may be a natural number as a testable frequency number, A [x] may be a requested frequency, B [y] may be a testable frequency, variable z may be a comparison constant whose initial value is an integer greater than | A [1] - B [1] | , and C [x] may be a test frequency.

According to another aspect of the present disclosure, an impedance measurement system includes: a conversion communication unit that receives a request message including information of a test input value including a start frequency, an end frequency, and the number of frequencies from a user terminal; and a conversion control unit that calculates a plurality of request frequencies corresponding to the number of frequencies based on the test input values, and matches a plurality of testable frequencies stored in a lookup table with the plurality of request frequencies to determine a plurality of test frequencies, in which the conversion communication unit transmits the plurality of test frequencies to a test apparatus that is an impedance measurement apparatus for a battery cell under control of the conversion control unit.

The conversion control unit may convert each of the start frequency and the end frequency into a common log to calculate a logic start frequency and a logic end frequency, divide the logic start frequency to the logic end frequency into equal intervals to calculate a plurality of logic equal interval frequencies corresponding to the number of frequencies, and inversely convert the plurality of logic equal interval frequencies into a common log to calculate the plurality of request frequencies.

The conversion control unit may determine, for each of the plurality of request frequencies, a first testable frequency corresponding to a size closest to a size of a first request frequency among the plurality of testable frequencies as a first test frequency corresponding to the first request frequency.

The conversion control unit may determine a second testable frequency corresponding to a size next closer to a size of a second request frequency as a second test frequency corresponding to the second request frequency when a size of a second request frequency among the plurality of testable frequencies is closest to the first testable frequency.

The conversion control unit may determine whether Equation (1) or Equation (2) is satisfied for each of the plurality of request frequencies, apply Equations (3) and (4) and then determine again whether Equations (1) and (2) are satisfied when it is determined as the determination result that neither Equation (1) nor Equation (2) is satisfied, and apply Equation (5) to determine the test frequency, when it is determined as the determination result when Equation (1) or Equation (2) is satisfied.

$$z \leq |\ A\ [x]\ -\ B\ [y]\ |\ \ -\text{Equation (1)}$$

$$y = n - 2 - \text{Equation (2)}$$

$$y = y + 1 - \text{Equation (3)}$$

$$z = |\ A\ [x]\ -\ B\ [y]\ |\ \ -\ \text{Equation (4)}$$

$$A\ [x]\ =\ C\ [x]\ =\ B\ [y-1]\ \ -\ \text{Equation (5)}$$

Here, variable x may be a natural number as a request frequency number, variable y may be a natural number as a testable frequency number, A [x] may be a requested frequency, B [y] may be a testable frequency, variable z may be a comparison constant whose initial value is an integer greater than | A [1] - B [1] | , and C [x] may be a test frequency.

According to still another aspect of the present disclosure, an impedance measurement method includes receiving, by a conversion device, a request message including information of a test input value including a start frequency, an end frequency, and the number of frequencies from a user terminal; and calculating a plurality of request frequencies corresponding to the number of frequencies based on the test input values; matching a plurality of testable frequencies stored in a lookup table with the plurality of request frequencies to determine a plurality of test frequencies; and transmitting the plurality of test frequencies to a test apparatus that is an impedance measurement apparatus for a battery cell.

The calculating of the plurality of request frequencies may include converting each of the start frequency and the end frequency into a common log to calculate a logic start frequency and a logic end frequency, dividing the logic start frequency to the logic end frequency into equal intervals to calculate a plurality of logic equal interval frequencies corresponding to the number of frequencies, and inversely converting the plurality of logic equal interval frequencies into a common log to calculate the plurality of request frequencies.

The determining of the plurality of test frequencies may include determining a first testable frequency corresponding to a size closest to a size of a first request frequency among the plurality of testable frequencies, and determining the first testable frequency as a first test frequency corresponding to the first request frequency when the first testable frequency is not determined as a test frequency.

The determining of the plurality of test frequencies may include, for each of the plurality of request frequencies, a first step of determining whether Equation (1) or Equation (2) is satisfied, a second step of applying Equations (3) and (4) below and then proceeding to the first step when it is determined as the determination result that neither Equation (1) nor Equation (2) is satisfied, and a third step of applying Equation (5) to determine the test frequency, when it is determined as the determination result when Equation (1) or Equation (2) is satisfied.

$$z \leq\ |\ A\ [x]\ -\ B\ [y]\ |\ \ -\ \text{Equation (1)}$$

$$y = n - 2 - \text{Equation (2)}$$

$$y = y + 1 - \text{Equation (3)}$$

$$z = |\ A\ [x]\ -\ B\ [y]\ |\ \ -\ \text{Equation (4)}$$

$$A\ [x]\ =\ C\ [x]\ =\ B\ [y-1]\ \ -\ \text{Equation (5)}$$

Here, variable x is a natural number as a request frequency number, variable y is a natural number as a testable frequency number, A [x] is a request frequency, B [y] is a testable frequency, variable z is a comparison constant whose initial value is an integer greater than | A [1] - B [1] | , and C [x] is a test frequency.

**[Advantageous Effects]**

According to the present disclosure, it is possible to estimate the impedance of a battery cell based on a plurality of request frequencies desired by a user.

According to the present disclosure, it is possible to provide a user with a highly reliable test result by preventing a plurality of test frequencies corresponding to a plurality of request frequencies desired by a user from overlapping.

**[Description of the Drawings]**

FIG. 1 is a block diagram for describing a system for measuring an impedance of a battery cell according to an embodiment.

FIG. 2 is a flowchart for describing an impedance measurement method of a battery cell according to another embodiment.

FIG. 3 is a flowchart for describing in detail a step (S130a) of determining a plurality of test frequencies of FIG. 2.

FIG. 4 is a flowchart for describing an impedance measurement method of a battery cell according to still another embodiment.

FIG. 5 is a flowchart for describing in detail a step (S200b) of determining a plurality of test frequencies of FIG. 4.

FIG. 6 is a flowchart for explaining in detail steps 130a and 200b of determining a plurality of test frequencies according to still another embodiment in a mathematical concept.

**[Mode for Invention]**

Hereafter, embodiments of the present disclosure will be described in detail with reference to the accompanying drawings and the same or similar components are given the same reference numerals and are not repeatedly described. The suffix "module" and/or "unit" for components used in the following description is given or mixed in consideration of only the ease of writing of the specification, and therefore, do not have meanings or roles that distinguish from each other in themselves. In addition, when it is determined that a detailed description for the known art related to embodiments disclosed in the present specification may obscure the gist of the embodiments disclosed in present specification, the detailed description will be omitted. Further, it should be understood that the accompanying drawings are provided only in order to allow exemplary embodiments of the present disclosure to be easily understood, and the spirit of the present disclosure is not limited by the accompanying drawings, but includes all the modifications, equivalents, and substitutions included in the spirit and the scope of the present disclosure.

Terms including an ordinal number such as first, second, etc., may be used to describe various components, but the components are not limited to these terms. The above terms are used solely for the purpose of distinguishing one component from another.

In the present specification, it is to be understood that when one component is referred to as being "connected to" or "coupled to" another component, it may be connected or coupled directly to another component or be connected to another component with the other component interposed therebetween. On the other hand, it should be understood that when one element is referred to as being "connected directly to" or "coupled directly to" another element, it may be connected to or coupled to another element without the other element interposed therebetween.

It will be further understood that terms "include" or "have" used in the present specification specify the presence of features, numerals, steps, operations, components, parts mentioned in the present specification, or combinations thereof, but do not preclude the presence or addition of one or more other features, numerals, steps, operations, components, parts, or combinations thereof.

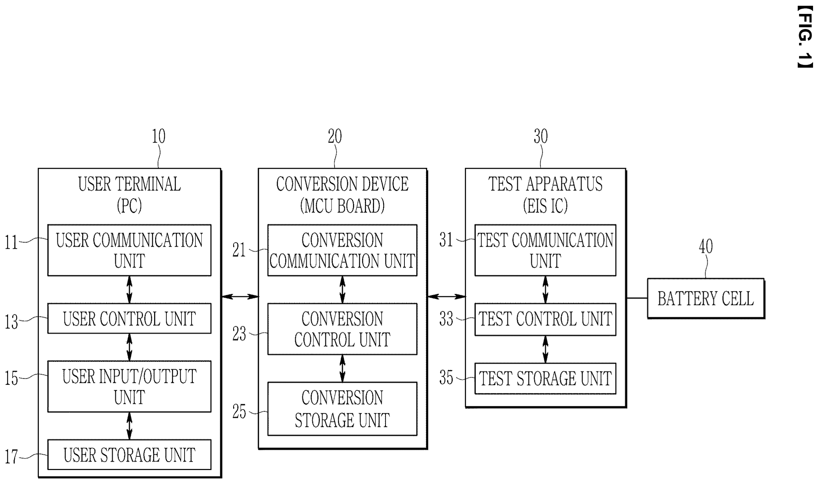

FIG. 1 is a block diagram for describing a system for measuring an impedance of a battery cell according to an embodiment.

The impedance measurement system includes a user terminal 10, a conversion device 20, a test apparatus 30, and a battery cell 40.

The user terminal 10 may be a terminal device used by a user who wishes to measure impedance of a battery cell. In FIG. 1, the user terminal 10 is illustrated as a personal computer (PC), which is a small computer used by an individual, but is not limited thereto. For example, the user terminal 10 may include a desktop PC, a tablet PC, a slate PC, a notebook computer, a digital broadcasting terminal, personal digital assistants (PDAs), a portable multimedia player (PMP), a navigation, a digital camera, an MPEG layer 3 player (MP3P), etc. In addition, it is obvious that the terminal device applicable to the user terminal 10 is not limited to the types described above, and may include all terminal devices capable of communicating with external devices.

Referring to FIG. 1, the user terminal 10 may include a user communication unit 11, a user control unit 13, a user input/output unit 15, and a user storage unit 17.

The user communication unit 11 may be connected to a communication network and transmit and receive data to and from the conversion device 20. The user communication unit 11 may be connected to the communication network through a communication method of the GSM/3GPP series (GSM, HSDPA, LTE Advanced), a communication method of the 3GPP2 series (CDMA, etc.), or a wireless communication protocol such as WiMAX, but is not limited thereto. For example, the user communication unit 11 may be connected to the communication network through a conventional communication protocol or a communication protocol to be developed according to the development of future technology.

The user control unit 13 may control the user terminal 10 as a whole and transmit commands, etc., input by the user through the user communication unit 11 to the conversion device 20 so that the test desired by the user may be performed.

The user input/output unit 15 may display various types of interfaces to receive test input values (e.g., start frequency, end frequency, and number of frequencies) from the user. In addition, the user input/output unit 15 may display test result values, which are the results of the test performed based on the test input values, to the user.

For example, the user input/output unit 15 may include display means such as a display panel (Plasma Display Panel (PDP)), a liquid crystal display (LCD) panel, a light emitting diode (LED) panel, an organic light emitting diode (OLED) panel, an active-matrix organic light-emitting diode (AMOLED) panel, etc., for displaying the above-described information.

For another example, the user input/output unit 15 may include a button input means such as a keypad, a push button, or a membrane button, a touch input means such as a touch pad, etc., to receive information from the user, and may be implemented in the form of a touch screen capable of both input and output.

The user storage unit 17 may store data, algorithms, etc., required for the user terminal 10 to operate. The user storage unit 17 may include, for example, a storage medium such as a random access memory (RAM), a static random access memory (SRAM), a read only memory (ROM), a programmable read only memory (PROM), or an electrically erasable programmable read only memory (EEPROM).

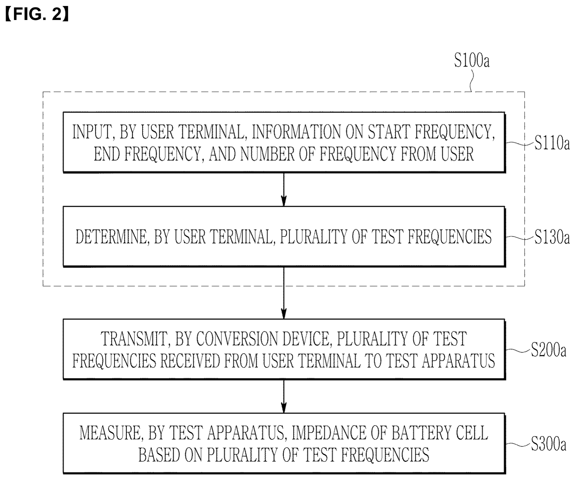

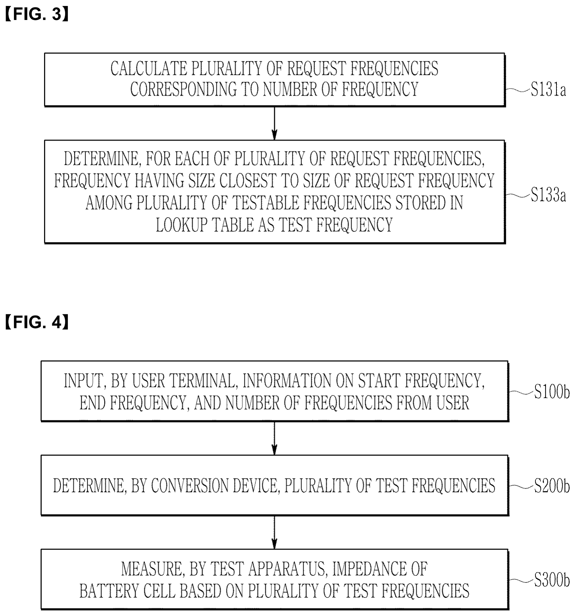

According to an exemplary embodiment, the user storage unit 17 may store a frequency change algorithm that calculates a plurality of request frequencies based on test input values input from a user through the user input/output unit 15, and determine a plurality of test frequencies corresponding to the plurality of request frequencies. The frequency change algorithm will be described in more detail with reference to FIGS. 2 and 3 below.

The conversion device 20 may connect communication between the user terminal 10 used by the user and the test apparatus 30 performing the test. In FIG. 1, the conversion device 20 is illustrated as a micro controller unit (MCU) board, but is not limited thereto. For example, the conversion device 20 may include various types of control devices, communication conversion devices, etc., mounted on a battery system or an automobile system. In this case, the automobile system may be an upper system mounted on a battery system.

For example, when the communication modules used by the user terminal 10 and the test apparatus 30 are different, the conversion device 20 may control the user terminal 10 and the test apparatus 30 to be able to communicate with each other by changing the format of the data transmitted and received between the user terminal 10 and the test apparatus 30.

Referring to FIG. 1, the conversion device 20 may include a conversion communication unit 21, a conversion control unit 23, and a conversion storage unit 25.

The conversion communication unit 21 may include a first communication module that is connected to a communication network and transmits and receives data to and from the user terminal 10. The conversion communication unit 21 may include a second communication module that transmits and receives data to and from the test apparatus 30.

The conversion control unit 23 may control the communication connection between the user terminal 10 used by the user and the test apparatus 30 performing the test. For example, the conversion control unit 23 may receive a test input value from the user terminal 10 through the conversion communication unit 21, convert the test input value into the form that the test apparatus 30 can receive, and transmit the test input value to the test apparatus 30. For another example, the conversion control unit 23 may receive a test result value from the test apparatus 30 through the conversion communication unit 21, convert the test result value into a form that the user terminal 10 can receive, and transmit the test result value to the user terminal 10.

The conversion storage unit 25 may store data, algorithms, etc., required for the conversion device 20 to operate. For example, the conversion storage unit 25 may store a first communication module and a second communication module.

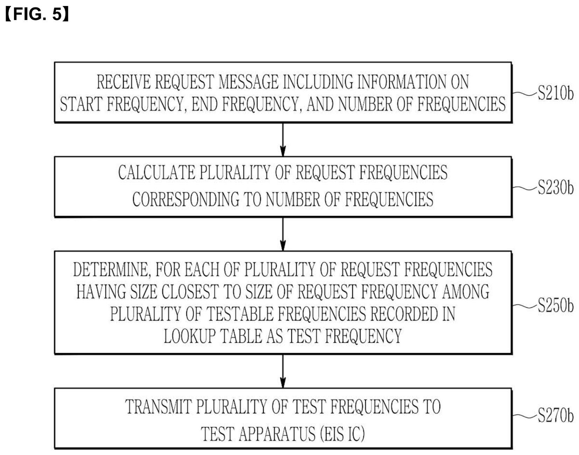

According to another exemplary embodiment, the conversion device 20 may store a frequency change algorithm that calculates the plurality of request frequencies based on the test input value input from the user through the user terminal 10, and determines a plurality of test frequencies corresponding to the plurality of request frequencies. The frequency change algorithm will be described in more detail with reference to FIGS. 4 and 5 below.

The test apparatus 30 may be connected to the battery cell 40 and may measure the impedance of the battery cell 40. For example, the test apparatus 30 may find the impedance value of the battery cell 40 corresponding to a predetermined frequency.

Referring to FIG. 1, the test apparatus 30 includes a test communication unit 31, a test control unit 33, and a test storage unit 35.

The test communication unit 31 may include a communication module capable of communicating with the conversion device 20, and may transmit and receive data to and from the conversion device 20. The test communication unit 31 may receive a plurality of test frequencies from the conversion device 20 and transmit the test results to the conversion device 20.

The test control unit 33 may perform the test on each of the plurality of test frequencies targeting the battery cell 40. For example, the test control unit 33 may measure a plurality of impedances, which are test results for each of the plurality of test frequencies.

The test storage unit 35 may store data, algorithms, etc., required for the operation of the test apparatus 30. For example, the test storage unit 35 may store a lookup table in which a plurality of testable frequencies at which tests may be performed in the test apparatus 30 are stored. Depending on the exemplary embodiment, the lookup table may also be stored in the storage units 17 and 25 of each of the user terminal 10 and/or the conversion device 20.

(Table 1)

| No. | Testable Frequency |
|---|---|
| B[1] | 0.0149 |
| B[2] | 0.0298 |
| B[3] | 0.0596 |
| B[4] | 0.1192 |
| B[5] | 0.2384 |
| B[6] | 0.4768 |
| B[7] | 0.9537 |
| B[8] | 1.9074 |
| B[9] | 3.8147 |
| B[10] | 5.7221 |
| B[11] | 7.6294 |
| B[12] | 9.5368 |
| ... | ... |
| B[452] | 7629.4144 |
| B[453] | 7690.4497 |
| B[454] | 7751.485 |
| B[455] | 7812.5203 |

The above Table 1 is an example of the lookup table stored in the test storage unit 35. Due to various reasons such as design limitations, the frequency at which the test apparatus 30 may perform the test may be limited. That is, the testable frequencies at which the impedance measurement is possible through the test apparatus 30 may be stored in the test storage unit 35 in the form of the lookup table as shown in Table 1.

The battery cell 40 may be a rechargeable secondary battery. The inside of the battery cell 40 may include an electrochemical structure. For example, when a plurality of impedance values corresponding to each of the plurality of test frequencies are measured through the test apparatus 30, an electrical equivalent circuit of the battery cell 40 may be calculated based on the plurality of impedance values. An equivalent circuit of the battery cell 40 may be used as auxiliary data to estimate the deterioration (state of health (SOH)) in the battery cell 40, the temperature of the battery cell 40, and a state of charge (SOC) of the battery cell 40.

FIG. 2 is a flowchart for describing an impedance measurement method of a battery cell according to another embodiment. FIG. 3 is a flowchart for describing in detail a step (S130a) of determining a plurality of test frequencies of FIG. 2.

Referring to FIG. 2, first, the user terminal 10 receives the test input value from the user and determines the plurality of test frequencies (S100a).

According to an exemplary embodiment, the user terminal 10 may determine the plurality of test frequencies necessary for measuring the impedance of the battery cell 40. The test frequency may be a frequency at which the test apparatus 30 tests the battery cell 40 to measure the impedance of the battery cell 40.

In step S100a, the user terminal 10 receives test input values including a start frequency, an end frequency, and the number of frequencies from the user (S110a).

The user input/output unit 15 may display various types of interfaces to receive the test input values (e.g., start frequency, end frequency, and the number of frequencies) from the user.

In step S100a, the user terminal 10 determines the plurality of test frequencies (S130a).

Referring to FIG. 3, in step S130a, the user terminal 10 calculates the plurality of request frequencies corresponding to the number of frequencies (S131a).

The user terminal 10 calculates a logic start frequency and a logic end frequency by converting each of the start frequency and the end frequency into a common log. Then, the user terminal 10 calculates a plurality of logic equal interval frequencies corresponding to the number of frequencies by dividing the logic start frequency to the logic end frequency into equal intervals. The plurality of request frequencies may be calculated by inversely converting the plurality of logic equal interval frequencies into the common log.

For example, it is assumed that the start frequency is 0.1 Hz, the end frequency is 1000 Hz, and the number of frequencies is 21. The user terminal 10 performs a common log transformation on the start frequency (0.1 Hz) and the end frequency (1000 Hz), respectively, to calculate a logic start frequency (log 0.1=-1) and a logic end frequency (log1000=3). The user terminal 10 divides the frequency from the logic start frequency (log0.1=-1) to the logic end frequency (log1000=3) into equal intervals so that the number of frequencies 21 is calculated, and calculates the plurality of logic equal interval frequencies corresponding to the number of frequencies 21. The user terminal 10 performs a common log inverse transformation on each of the plurality of logic equal interval frequencies to calculate the plurality of request frequencies.

(Table 2)

| No. | Log Equal Interval Frequency | Request Frequency |
|-----|------------------------------|-------------------|
| 1 | 3 | 1000 |
| 2 | 2.8 | 630.9573 |
| 3 | 2.6 | 398.1072 |
| 4 | 2.4 | 251.1886 |
| 5 | 2.2 | 158.4893 |
| 6 | 2 | 100 |
| 7 | 1.8 | 63.09573 |
| 8 | 1.6 | 39.81072 |
| 9 | 1.4 | 25.11886 |
| 10 | 1.2 | 15.84893 |
| 11 | 1 | 10 |
| 12 | 0.8 | 6.309573 |
| 13 | 0.6 | 3.981072 |
| 14 | 0.4 | 2.511886 |
| 15 | 0.2 | 1.584893 |
| 16 | 0 | 1 |
| 17 | -0.2 | 0.630957 |
| 18 | -0.4 | 0.398107 |
| 19 | -0.6 | 0.251189 |
| 20 | -0.8 | 0.158489 |
| 21 | -1 | 0.1 |

The above Table 2 is an example of displaying a plurality of logic interval frequencies and a plurality of request frequencies corresponding to a start frequency of 0.1 Hz, an end frequency of 1000 Hz, and a frequency number of 21. That is, 21 request frequencies from Nos. 1 to 21 may correspond to the frequencies requested by the user for performing the test. The test apparatus 30 may not be able to perform the test on all the frequencies desired by the user. Therefore, a process of determining a testable frequency closest to the request frequency requested by the user as the test frequency is necessary.

Referring to FIG. 3, in step S130a, the user terminal 10 determines, for each of the plurality of request frequencies, a testable frequency having a size closest to the size of the request frequency among the plurality of testable frequencies stored in the lookup table as the test frequency (S133a).

For example, each of the plurality of testable frequencies (see Table 1) and the plurality of request frequencies (see Table 2) stored in the lookup table may be sorted in order of size (ascending or descending). Thereafter, from the smallest request frequency to the largest request frequency, the testable frequency that is closest to the size of the request frequency among the plurality of testable frequencies may be determined as the test frequency.

(Table 3)

| No. | Request Frequency |
|---|---|
| A[1] | 0.1 |
| A[2] | 0.158489 |
| A[3] | 0.251189 |
| A[4] | 0.398107 |
| A[5] | 0.630957 |
| A[6] | 1 |
| A[7] | 1.584893 |
| A[8] | 2.511886 |
| A[9] | 3.981072 |
| A[10] | 6.309573 |
| A[11] | 10 |
| A[12] | 15.84893 |
| A[13] | 25.11886 |
| A[14] | 39.81072 |
| A[15] | 63.09573 |
| A[16] | 100 |
| A[17] | 158.4893 |
| A[18] | 251.1886 |
| A[19] | 398.1072 |
| A[20] | 630.9573 |
| A[21] | 1000 |

The above Table 3 is the size of the plurality of request frequencies listed in the above Table 2 sorted in ascending order.

According to the exemplary embodiment, the user terminal 10 may exclude the previously selected testable frequency from the frequency matching process so that the testable frequency of the same size is not duplicated and matched to two different request frequencies. The user terminal 10 determines a first testable frequency corresponding to a size closest to a size of a first request frequency among the plurality of testable frequencies as the first test frequency corresponding to the first request frequency. After the first testable frequency is determined as the first test frequency, even if the first testable frequency is closest to a size of a second request frequency, the user terminal 10 may determine a second testable frequency that is next closest to the size of the second request frequency as the second test frequency corresponding to the second request frequency.

For example, referring to Table 3 above, it is assumed that the first request frequency is 0.1 Hz and the second request frequency is 0.158489. When the first request frequency (0.1 Hz) matches the lookup table (Table 1), the testable frequency with the closest size is 0.1192 Hz. The user terminal 10 may determine the first test frequency corresponding to the first request frequency (0.1 Hz) as 0.1192 Hz. Also, when matching the second requested frequency (0.158489 Hz) with the lookup table (Table 1), the testable frequency closest to the second request frequency (0.158489 Hz) is 0.1192 Hz (which is the same size as the first test frequency). However, in order to avoid duplication, the user terminal 10 may determine 0.2384 Hz, which is a testable frequency that is next closest to the second request frequency (0.158489 Hz), as the second test frequency corresponding to the second request frequency (0.158489 Hz). Table 4 below is an example of 21 test frequencies calculated by matching each of the 21 request frequencies shown in Table 3 with the lookup table in Table 1.

(Table 4)

| No. | Test Frequency |
| --- | --- |
| C[1] | 0.1192 |
| C[2] | 0.2384 |
| C[3] | 0.4768 |
| C[4] | 0.9537 |
| C[5] | 1.9074 |
| C[6] | 3.8147 |
| C[7] | 5.7221 |
| C[8] | 7.6294 |
| C[9] | 9.5368 |
| C[10] | 11.4441 |
| C[11] | 13.3515 |
| C[12] | 15.2588 |
| C[13] | 24.7956 |
| C[14] | 40.0544 |
| C[15] | 62.9427 |
| C[16] | 99.1824 |
| C[17] | 158.3103 |
| C[18] | 251.7707 |
| C[19] | 396.7295 |
| C[20] | 633.2414 |
| C[21] | 1007.083 |

Next, the conversion device 20 transmits the plurality of test frequencies received from the user terminal 10 to the test apparatus 30 (200a).

When the communication modules used by the user terminal 10 and the test apparatus 30 are different, the conversion device 20 may control the user terminal 10 and the test apparatus 30 to be able to communicate with each other by changing the communication form of the data transmitted and received between the user terminal 10 and the test apparatus 30.

Next, the test apparatus 30 measures the impedance of the battery cell 40 based on the plurality of received test frequencies (S300a).

The test apparatus 30 may transmit a plurality of impedance values corresponding to each of the plurality of test frequencies to the user terminal 10 through the conversion device 20. For example, when the plurality of impedance values corresponding to each of the plurality of test frequencies are measured through the test apparatus 30, the electrical equivalent circuit of the battery cell 40 may be calculated based on the plurality of impedance values. The equivalent circuit of the battery cell 40 may be used as the auxiliary data to estimate the deterioration (state of health (SOH)) in the battery cell 40, the temperature of the battery cell 40, and the state of charge (SOC) of the battery cell 40.

FIG. 4 is a flowchart for describing an impedance measurement method of a battery cell according to another embodiment. FIG. 5 is a flowchart for describing in detail a step (S200b) of determining the plurality of test frequencies of FIG. 4.

In FIGS. 2 and 3, a user terminal 100 determines the plurality of test frequencies according to another exemplary embodiment. In FIGS. 4 and 5, the conversion device 20 determines the plurality of test frequencies according to another exemplary embodiment.

Referring to FIG. 4, first, the user terminal 10 receives test input values including a start frequency, an end frequency, and a number of frequencies (S100b).

The user terminal 10 may display various types of interfaces to receive test input values (e.g., a start frequency, an end frequency, and a number of frequencies) from a user. The user terminal 10 transmits the test input value to the conversion device 20.

Next, the conversion device 20 determines the plurality of test frequencies based on the received test input values (S200b).

In step S200b, referring to FIG. 5, the conversion device 20 receives a request message including the information on the start frequency, the end frequency, and the number of frequencies from the user terminal 100 (S210b).

In step S200b, the conversion device 20 calculates the plurality of request frequencies corresponding to the number of frequencies (S230b).

The conversion device 20 converts each of the start frequency and the end frequency into the common log to calculate the logic start frequency and the logic end frequency. Then, the user terminal 10 calculates a plurality of logic equal interval frequencies corresponding to the number of frequencies by dividing the logic start frequency to the logic end frequency into equal intervals. The plurality of request frequencies may be calculated by inversely converting the plurality of logic equal interval frequencies into the common log.

For example, referring to Table 2 above, it is assumed that the start frequency is 0.1 Hz, the end frequency is 1000 Hz, and the number of frequencies is 21. The conversion device 20 calculates the logic start frequency (log0.1=-1) and the logic end frequency (log1000=3) by converting each of the start frequency (0.1 Hz) and the end frequency (1000 Hz) into the common log. The conversion device 20 divides the frequency from the logic start frequency (log0.1=-1) to the logic end frequency (log1000=3) into equal intervals so that the number of frequencies, which is 21, is calculated, and calculates the plurality of logic equal interval frequencies corresponding to the number of frequencies, which is 21. The conversion device 20 performs a common log inverse transformation on each of the plurality of logic equal interval frequencies to calculate the plurality of request frequencies.

In step S200b, the conversion device 20 determines, for each of the plurality of request frequencies, a testable frequency having a size closest to the size of the request frequency among the plurality of testable frequencies stored in the lookup table as the test frequency (S250b).

For example, each of the plurality of testable frequencies (see Table 1) and the plurality of request frequencies (see Table 3) stored in the lookup table may be sorted in order of size (ascending). Thereafter, from the smallest request frequency to the largest request frequency, the testable frequency that is closest to the size of the request frequency among the plurality of testable frequencies may be determined as the test frequency.

According to the exemplary embodiment, the conversion device 20 may exclude the previously selected testable frequency from the frequency matching process so that the testable frequency of the same size is not duplicated and matched to two different request frequencies. The conversion device 20 determines a first testable frequency corresponding to a size closest to a size of a first request frequency among the plurality of testable frequencies as the first test frequency corresponding to the first request frequency. After the first testable frequency is determined as the first test frequency, even if the first testable frequency is closest to a size of a second request frequency, the conversion device 20 may determine a second testable frequency that is next closest to the size of the second request frequency as the second test frequency corresponding to the second request frequency.

For example, referring to Table 3 above, it is assumed that the first request frequency is 0.1 Hz and the second request frequency is 0.158489. When matching the first request frequency (0.1 Hz) with the lookup table (Table 1), the closest testable frequency is 0.1192 Hz. The conversion device 20 may determine the first test frequency corresponding to the first request frequency (0.1 Hz) as 0.1192 Hz. Also, when matching the second requested frequency (0.158489 Hz) with the lookup table (Table 1), the testable frequency of a size closest to the second request frequency (0.158489 Hz) is 0.1192 Hz (which is the same size as the first test frequency). However, in order to avoid duplication, the conversion device 20 may determine 0.2384 Hz, which is a testable frequency that is next closest to the second request frequency (0.158489 Hz), as the second test frequency corresponding to the second request frequency (0.158489 Hz).

In step S200b, the conversion device 20 transmits the plurality of test frequencies to the test apparatus 30 (EIS IC) (270b).

When the communication modules used by the user terminal 10 and the test apparatus 30 are different, the conversion device 20 may control the user terminal 10 and the test apparatus 30 to be able to communicate with each other by changing the communication form of the data transmitted and received between the user terminal 10 and the test apparatus 30.

Next, the test apparatus 30 measures the impedance of the battery cell 40 based on the plurality of received test frequencies (S300b).

The test apparatus 30 may transmit the plurality of impedance values corresponding to each of the plurality of test frequencies to the user terminal 10 through the conversion device 20. When the plurality of impedance values corresponding to each of the plurality of test frequencies are extracted through the test apparatus 30, the electrical equivalent circuit of the battery cell 40 may be calculated based on the plurality of impedance values. The equivalent circuit of the battery cell 40 may be used as the auxiliary data to estimate the deterioration (state of health (SOH)) in the battery cell 40, the temperature of the battery cell 40, and the state of charge (SOC) of the battery cell 40.

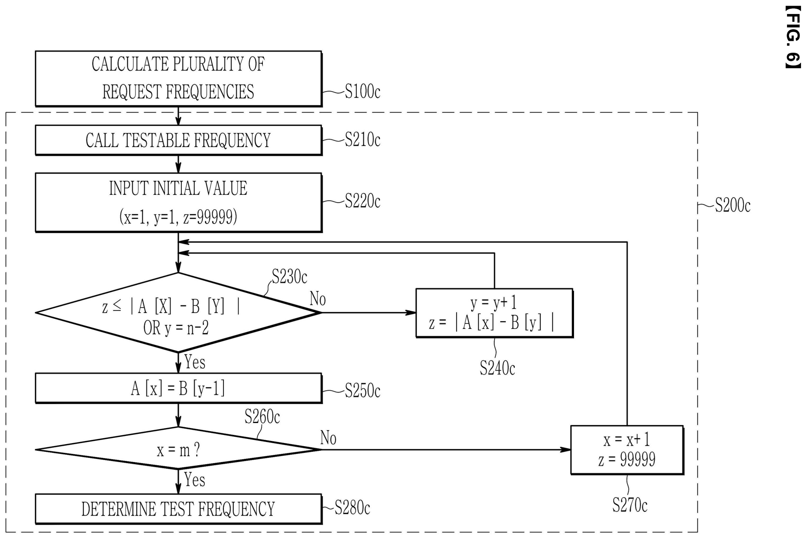

FIG. 6 is a flowchart for explaining in detail steps 130a and 200b of determining the plurality of test frequencies according to another embodiment in a mathematical concept.

Referring to FIG. 6, the step (S100c) of calculating the plurality of request frequencies may correspond to the step (S131a) of calculating the plurality of request frequencies according to another exemplary embodiment of FIG. 3 and the step (S230b) of calculating the plurality of request frequencies according to another exemplary embodiment of FIG. 5, respectively. Therefore, the description of the step (S100c) of calculating the plurality of request frequencies is omitted. In addition, although it is described below that the plurality of test frequencies are determined in the user terminal 10, it is not limited thereto, and the same may be applied to the plurality of test frequencies being determined in the conversion device 20.

Next, the user terminal 10 determines, for each of the plurality of request frequencies, a testable frequency having a size closest to the size of the request frequency among the plurality of testable frequencies recorded in the lookup table as the test frequency (S200c).

Referring to FIG. 6, the step (S200c) of determining the test frequency may correspond to the step (S133a) of determining the test frequency according to another exemplary embodiment of FIG. 3 and the step (S250b) of determining the test frequency according to another exemplary embodiment of FIG. 5, respectively. Specifically, the step (S200c) of determining the test frequency may be a step of mathematically describing in detail a method of excluding preselected testable frequencies from the frequency matching process so that testable frequencies of the same size are not duplicated and matched to two different request frequencies.

(Table 5)

| x | y | z | Request Frequency | | Testable Frequency | | \|A[x]-B[y]\| | Proposition 1 | Proposition 2 | Result | |
|---|---|---|---|---|---|---|---|---|---|---|---|
| 1 | 1 | 99999 | A[1] | 0.1 | B[1] | 0.0149 | 0.0851 | FALSE | FALSE | | |
| 1 | 2 | 0.0851 | A[1] | 0.1 | B[2] | 0.0298 | 0.0702 | FALSE | FALSE | | |
| 1 | 3 | 0.0702 | A[1] | 0.1 | B[3] | 0.0596 | 0.0404 | FALSE | FALSE | | |
| 1 | 4 | 0.0404 | A[1] | 0.1 | B[4] | 0.1192 | 0.0192 | FALSE | FALSE | | |
| 1 | 5 | 0.0192 | A[1] | 0.1 | B[5] | 0.2384 | 0.1384 | TRUE | FALSE | A[1] | 0.1192 |
| 2 | 5 | 99999 | A[2] | 0.158489319 | B[5] | 0.2384 | 0.079911 | FALSE | FALSE | | |
| 2 | 6 | 0.079911 | A[2] | 0.158489319 | B[6] | 0.4768 | 0.318311 | TRUE | FALSE | A[2] | 0.2384 |
| 3 | 6 | 99999 | A[3] | 0.251188643 | B[6] | 0.4768 | 0.225611 | FALSE | FALSE | | |
| 3 | 7 | 0.225611 | A[3] | 0.251188643 | B[7] | 0.9537 | 0.702511 | TRUE | FALSE | A[3] | 0.4768 |
| | | | | | ... | | | | | | |
| 21 | 260 | 53.9526 | A[21] | 1000 | B[260] | 953.6768 | 46.3232 | FALSE | TRUE | | |
| 21 | 261 | 46.3232 | A[21] | 1000 | B[261] | 961.3062 | 38.6938 | FALSE | TRUE | | |
| 21 | 262 | 38.6938 | A[21] | 1000 | B[262] | 968.9356 | 31.0644 | FALSE | TRUE | | |
| 21 | 263 | 31.0644 | A[21] | 1000 | B[263] | 976.565 | 23.435 | FALSE | TRUE | | |
| 21 | 264 | 23.435 | A[21] | 1000 | B[264] | 991.8239 | 8.1761 | FALSE | TRUE | | |
| 21 | 265 | 8.1761 | A[21] | 1000 | B[265] | 1007.0827 | 7.0827 | FALSE | TRUE | | |
| 21 | 266 | 7.0827 | A[21] | 1000 | B[266] | 1022.3415 | 22.3415 | TRUE | TRUE | A[21] | 1007.083 |

The above Table 5 is an example of a process sequentially described according to the progress of the step (S200c) of determining the test frequency of FIG. 6, and is calculated based on the testable frequency of Table 1 and the request frequency of Table 3. The plurality of test frequencies, which are the results derived by FIG. 6 and Table 5, may correspond to the plurality of test frequencies described in Table 4. In each step below, the process of determining the first test frequency (C[1], 0.1192) corresponding to the first request frequency (A[1], 0.1) disclosed in Table 5 will be described as an example. However, it is not limited thereto, and the second to twenty-first test frequencies (C[2] to C[21]) corresponding to the second to twenty-first request frequencies (A[2] to A[21]) may also be determined in the same manner.

In step S200, the user terminal 10 calls the plurality of testable frequencies (S210c). The testable frequency may be a frequency at which the test may be performed in the test apparatus 30. For example, the plurality of testable frequencies may be stored in the user storage unit 17 in the form of the lookup table as shown in Table 1. For another example, when the plurality of test frequencies are determined in the conversion device 20, the plurality of testable frequencies may be stored in the conversion storage unit 25 in the form of the lookup table as shown in Table 1.

In step S200, the user terminal 10 inputs initial values of variables (S220c).

Depending on the exemplary embodiment, the plurality of variables may include x, y, and z, and may be directly input by the user through the user terminal 10 or may be preset and automatically input by the user terminal 10. In this case, variable x is the number of request frequencies, variable y is the number of testable frequencies, and variable z is a comparison constant. For example, referring to the first line of FIG. 6 and Table 5, the initial values of each of the variables x and y are '1', and the initial value of the variable z may be input as '99999'. However, the initial value of the variable z is not limited to '99999', and any number may be set as long as it is a very large number that makes the initial determination result for the following Equation 1 NO.

**[0100]** In step S200, the user terminal 10 determines whether the following Equation 1 or the following Equation 2 is satisfied (S230c).

$$z \leq |A[x] - B[y]| \quad \text{- Equation (1)}$$

$$y = n - 2 \quad \text{- Equation (2)}$$

In Equation (1), A[x] denotes the size of the request frequency in Table 3 and Table 5, and B[y] denotes the size of the testable frequency in Table 1 and Table 5. For reference, C[x] in Table 4 denotes the test frequency. In this case, Tables 1 and 3 may be arranged in ascending order of the frequency size. In Equation 2, variable n denotes the number of testable frequencies. For example, referring to Table 1, n is 455.

Referring to Table 5, Proposition 1 is the result of Equation (1), and since the size of the first request frequency (A[1]) is 0.1 and the first testable frequency (B[1]) is 0.0149, the size of |A[1] - B[1]| is 0.0851. Since the initial input value of the variable z is 99999, the result of Equation (1) is FALSE. In addition, since n is 455 and y is the initial input value of '1', the result of Equation (2) is also FALSE. That is, the result of Proposition 1 in the first line of Table 5 is FALSE, which means that the first testable frequency (B[1], 0.0149) is not the first test frequency (C[1]) corresponding to the first request frequency (A[1]).

In step S200, when both Equations (1) and (2) are not satisfied (S230c, NO), the user terminal 10 applies the following Equations (3) and (4) (S240c).

$$y = y + 1 \quad \text{- Equation (3)}$$

$$z = |A[x] - B[y]| \quad \text{- Equation (4)}$$

For example, referring to a second line of Table 5, variable y is changed to 2 (y = 1 + 1 = 2), and variable z is changed to 0.0851 (z = |A[x] - B[y]| = |0.1-0.0149| = 0.0851). Thereafter, referring to the second line of FIG. 6 and Table 5, step S230c is repeated based on values 1, 2, and 0.0851 of the variables x, y, and z, respectively. Referring to Table 5, the result of the second line is also FALSE, which means that the second testable frequency (B[2] 0.0298) is not the first test frequency (C[1]) corresponding to the first request frequency (A[1]). Until this process, that is, steps S230c and S240c of FIG. 6 are repeated four times, the result of step S230c is FALSE. The details are disclosed in the third and fourth lines of Table 5.

In step S200, when the determination result of Equation (1) or Equation (2) is satisfied (S230c, YES), the user terminal 10 applies Equation (5) (S250c).

$$A\ [x]\ = B\ [y\text{-}1]\quad \text{- Equation (5)}$$

For example, referring to a fifth line of Table 5, variable x is 1, variable y is 5, and variable z is 0.0192. Reviewing step S230c of Fig. 6, the size of the first request frequency (A[1]) is 0.1, and the fifth testable frequency (B[5]) is 0.2384, so the size of | A [1] - B [5] | is 0.1384. Since the variable z is 0.0192, the result of Equation (1) (0.0192 ≤ 0.1384) is TRUE. Therefore, when Equation (5) is applied according to step S250c of FIG. 6, A [1] = B [5-1] = 0.1192 (in Table 1, B[4]= 0.1192). This is the result of the fifth line of Table 5. That is, the first test frequency (C[1]) corresponding to the first request frequency (A [1] ) is 0.1192.

In step S200, the user terminal 10 determines whether Equation (6) is satisfied (S260c).

$$x = m \text{ - Equation (6)}$$

In Equation (6), variable m is the number of frequencies requested by the user, i.e., the number of request frequencies. For example, referring to Table 3, n is 21. In Table 5, Proposition 2 corresponds to the result of Equation (6). Referring to the fifth line of Table 5, since variable x is 1, Equation (6) is not satisfied (1≠21). That is, the previously reviewed process is repeated as many times as the number of request frequencies.

In step S200, when the determination result is that Equation (6) is not satisfied (S260c, NO), the user terminal 10 applies Equations (7) and (8) below (S270c).

$$x = x + 1 \text{ - Equation (7)}$$

$$z = 99999 \text{ - Equation (8)}$$

Referring to the sixth line of Table 5, x = 2 (x = x + 1 = 1 + 1), and the variable z becomes 99999 again which is the same as the initial value. That is, the process of finding the first test frequency (C[1]) corresponding to the first request frequency (A[1]) is applied to the second request frequency (A[2]) in the same way. However, the variable y is not changed at this time. This is to prevent the testable frequency (B[y]) that was already matched with the first request frequency (A[1]) from being matched with the second request frequency (A[2]).

Thereafter, it starts again from step S230c.

In step S200, when the determination result of Equation (6) is satisfied (S260c, YES), the user terminal 10 determines the plurality of test frequencies derived from S200c (S280c).

For example, the plurality of test frequencies may be the same as the frequencies shown in Table 4.

Although the embodiments of the present disclosure have been described in detail above, the scope of the present disclosure is not limited thereto, and various modifications and improvements by those of ordinary skill in the field to which the present disclosure pertains belong to the scope of the present disclosure.

**Claims**

1.    An impedance measurement system, comprising:

a user input/output unit that receives test input values including a start frequency, an end frequency, and the number of frequencies from a user;
a user control unit that calculates a plurality of request frequencies corresponding to the number of frequencies based on the test input values, and matches a plurality of testable frequencies stored in a lookup table with the plurality of request frequencies to determine a plurality of test frequencies; and
a user communication unit that transmits the plurality of test frequencies to a test apparatus that is an impedance measurement apparatus for a battery cell.

2.    The impedance measurement system of claim 1, wherein:

the user control unit
converts each of the start frequency and the end frequency into a common log to calculate a logic start frequency and a logic end frequency, divides the logic start frequency to the logic end frequency into equal intervals to calculate a plurality of logic equal interval frequencies corresponding to the number of frequencies, and inversely converts the plurality of logic equal interval frequencies into a common log to calculate the plurality of request frequencies.

3. The impedance measurement system of claim 2, wherein:

    the user control unit
    determines, for each of the plurality of request frequencies, a first testable frequency corresponding to a size closest to a size of a first request frequency among the plurality of testable frequencies, as a first test frequency corresponding to the first request frequency.

4. The impedance measurement system of claim 3, wherein:

    the user control unit
    determines a second testable frequency corresponding to a size next closer to a size of a second request frequency as a second test frequency corresponding to the second request frequency when the size of the second request frequency among the plurality of testable frequencies is closest to the first testable frequency.

5. The impedance measurement system of claim 1, wherein:

    the user control unit
    determines whether Equation (1) or Equation (2) is satisfied for each of the plurality of request frequencies, applies Equations (3) and (4) and then determines again whether Equations (1) and (2) are satisfied, when the determination result shows that neither Equation (1) nor Equation (2) is satisfied, and
    applies Equation (5) to determine the test frequency, when it is determined as the determination result when Equation (1) or Equation (2) is satisfied.

$$z \leq \; | \, A \, [x] \, - B \, [y] \, | \; - \text{Equation (1)}$$

$$y = n - 2 - \text{Equation (2)}$$

$$y = y + 1 - \text{Equation (3)}$$

$$z = | \, A \, [x] \, - B \, [y] \, | \; - \text{Equation (4)}$$

$$A \, [x] \, = C \, [x] \, = B \, [y\text{-}1] \quad - \text{Equation (5)}$$

Here, variable x is a natural number as a request frequency number, variable y is a natural number as a testable frequency number, A [x] is a requested frequency, B [y] is the testable frequency, variable z is a comparison constant whose initial value is an integer greater than | A [1] - B [1] |, and C [x] is the test frequency.

6. An impedance measurement system, comprising:

    a conversion communication unit that receives a request message including information of a test input value including a start frequency, an end frequency, and the number of frequencies from a user terminal; and
    a conversion control unit that calculates a plurality of request frequencies corresponding to the number of frequencies based on the test input values, and matches a plurality of testable frequencies stored in a lookup table with the plurality of request frequencies to determine a plurality of test frequencies,
    wherein the conversion communication unit
    transmits the plurality of test frequencies to a test apparatus that is an impedance measurement apparatus for a battery cell under control of the conversion control unit.

7. The impedance measurement system of claim 6, wherein:

    the conversion control unit
    converts each of the start frequency and the end frequency into a common log to calculate a logic start frequency and a logic end frequency, divides the logic start frequency to the logic end frequency into equal intervals to calculate a plurality of logic equal interval frequencies corresponding to the number of frequencies, and inversely converts the plurality of logic equal interval frequencies into a common log to calculate the plurality of request frequencies.

8. The impedance measurement system of claim 7, wherein:

    the conversion control unit
    determines, for each of the plurality of request frequencies, a first testable frequency corresponding to a size closest to a size of a first request frequency among the plurality of testable frequencies, as a first test frequency corresponding to the first request frequency.

9. The impedance measurement system of claim 8, wherein:

    the conversion control unit
    determines a second testable frequency corresponding to a size next closer to a size of a second request frequency as a second test frequency corresponding to the second request frequency when the size of the second request frequency among the plurality of testable frequencies is closest to the first testable frequency.

10. The impedance measurement system of claim 6, wherein:

    the conversion control unit
    determines whether Equation (1) or Equation (2) is satisfied for each of the plurality of request frequencies, and applies Equations (3) and (4) and then determines again whether Equations (1) and (2) are satisfied when it is determined as the determination result that neither Equation (1) nor Equation (2) is satisfied, and
    applies Equation (5) to determine the test frequency, when it is determined as the determination result when Equation (1) or Equation (2) is satisfied.

$$z \leq \; | A\,[x] - B\,[y] \; | \; \text{- Equation (1)}$$

$$y = n - 2 \text{ - Equation (2)}$$

$$y = y + 1 \text{ - Equation (3)}$$

$$z = | A\,[x] - B\,[y] \; | \; \text{- Equation (4)}$$

$$A\,[x] = C\,[x] = B\,[y\text{-}1] \;\; \text{- Equation (5)}$$

Here, variable x is a natural number as a request frequency number, variable y is a natural number as a testable frequency number, A [x] is a requested frequency, B [y] is a testable frequency, variable z is a comparison constant whose initial value is an integer greater than | A [1] - B [1] |, and C [x] is a test frequency.

11. An impedance measurement method, comprising:

    receiving, by a conversion device, a request message including information of a test input value including a start frequency, an end frequency, and the number of frequencies from a user terminal;
    calculating a plurality of request frequencies corresponding to the number of frequencies based on the test input values;
    matching a plurality of testable frequencies stored in a lookup table with the plurality of request frequencies to determine a plurality of test frequencies; and
    transmitting the plurality of test frequencies to a test apparatus that is an impedance measurement apparatus for a battery cell.

12. The impedance measurement method of claim 11, wherein:

the calculating of the plurality of request frequencies includes
converting each of the start frequency and the end frequency into a common log to calculate a logic start frequency and a logic end frequency,
dividing the logic start frequency to the logic end frequency into equal intervals to calculate a plurality of logic equal interval frequencies corresponding to the number of frequencies, and
inversely converting the plurality of logic equal interval frequencies into a common log to calculate the plurality of request frequencies.

13. The impedance measurement method of claim 11, wherein:

the determining of the plurality of test frequencies includes
determining a first testable frequency corresponding to a size closest to a size of a first request frequency among the plurality of testable frequencies, and
determining the first testable frequency as a first test frequency corresponding to the first request frequency when the first testable frequency is not previously determined as a test frequency.

14. The impedance measurement method of claim 11, wherein:

the determining of the plurality of test frequencies includes for each of the plurality of request frequencies,
a first step of determining whether Equation (1) or Equation (2) is satisfied
a second step of applying Equations (3) and (4) below and then proceeding to the first step when it is determined as the determination result that neither Equation (1) nor Equation (2) is satisfied, and
a third step of applying Equation (5) to determine the test frequency, when it is determined as the determination result when Equation (1) or Equation (2) is satisfied.

$$z \leq |A[x] - B[y]| \quad \text{- Equation (1)}$$

$$y = n - 2 \quad \text{- Equation (2)}$$

$$y = y + 1 \quad \text{- Equation (3)}$$

$$z = |A[x] - B[y]| \quad \text{- Equation (4)}$$

$$A[x] = C[x] = B[y-1] \quad \text{- Equation (5)}$$

Here, variable x is a natural number as a request frequency number, variable y is a natural number as a testable frequency number, A [x] is a requested frequency, B [y] is a testable frequency, variable z is a comparison constant whose initial value is an integer greater than | A [1] - B [1] |, and C [x] is a test frequency.

【FIG. 1】

【FIG. 2】

S100a

INPUT, BY USER TERMINAL, INFORMATION ON START FREQUENCY, END FREQUENCY, AND NUMBER OF FREQUENCY FROM USER — S110a

DETERMINE, BY USER TERMINAL, PLURALITY OF TEST FREQUENCIES — S130a

TRANSMIT, BY CONVERSION DEVICE, PLURALITY OF TEST FREQUENCIES RECEIVED FROM USER TERMINAL TO TEST APPARATUS — S200a

MEASURE, BY TEST APPARATUS, IMPEDANCE OF BATTERY CELL BASED ON PLURALITY OF TEST FREQUENCIES — S300a

【FIG. 3】

CALCULATE PLURALITY OF REQUEST FREQUENCIES
CORRESPONDING TO NUMBER OF FREQUENCY — S131a

DETERMINE, FOR EACH OF PLURALITY OF REQUEST FREQUENCIES,
FREQUENCY HAVING SIZE CLOSEST TO SIZE OF REQUEST FREQUENCY
AMONG PLURALITY OF TESTABLE FREQUENCIES STORED IN
LOOKUP TABLE AS TEST FREQUENCY — S133a

【FIG. 4】

INPUT, BY USER TERMINAL, INFORMATION ON START FREQUENCY,
END FREQUENCY, AND NUMBER OF FREQUENCIES FROM USER — S100b

DETERMINE, BY CONVERSION DEVICE, PLURALITY OF TEST FREQUENCIES — S200b

MEASURE, BY TEST APPARATUS, IMPEDANCE OF
BATTERY CELL BASED ON PLURALITY OF TEST FREQUENCIES — S300b

【FIG. 5】

```
┌─────────────────────────────────────────────────────────┐
│ RECEIVE REQUEST MESSAGE INCLUDING INFORMATION ON          │ ──S210b
│ START FREQUENCY, END FREQUENCY, AND NUMBER OF FREQUENCIES  │
└─────────────────────────────────────────────────────────┘
                          │
                          ▼
┌─────────────────────────────────────────────────────────┐
│ CALCULATE PLURALITY OF REQUEST FREQUENCIES                │ ──S230b
│ CORRESPONDING TO NUMBER OF FREQUENCIES                     │
└─────────────────────────────────────────────────────────┘
                          │
                          ▼
┌─────────────────────────────────────────────────────────┐
│ DETERMINE, FOR EACH OF PLURALITY OF REQUEST FREQUENCIES    │
│ HAVING SIZE CLOSEST TO SIZE OF REQUEST FREQUENCY AMONG     │ ──S250b
│ PLURALITY OF TESTABLE FREQUENCIES RECORDED IN             │
│ LOOKUP TABLE AS TEST FREQUENCY                            │
└─────────────────────────────────────────────────────────┘
                          │
                          ▼
┌─────────────────────────────────────────────────────────┐
│ TRANSMIT PLURALITY OF TEST FREQUENCIES TO                 │ ──S270b
│ TEST APPARATUS (EIS IC)                                   │
└─────────────────────────────────────────────────────────┘
```

【FIG. 6】

## INTERNATIONAL SEARCH REPORT

| International application No. |
|---|
| **PCT/KR2024/014884** |

### A. CLASSIFICATION OF SUBJECT MATTER

**G01R 31/389**(2019.01)i; **G01R 23/02**(2006.01)i; **G01R 23/00**(2006.01)i; **G01R 31/371**(2019.01)i; **G01R 31/367**(2019.01)i

According to International Patent Classification (IPC) or to both national classification and IPC

### B. FIELDS SEARCHED

Minimum documentation searched (classification system followed by classification symbols)

G01R 31/389(2019.01); G01R 27/08(2006.01); G01R 31/36(2006.01); G01R 31/367(2019.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 전기화학 임피던스 분광법(electrochemical impedance spectroscopy), 주파수 (frequency), 측정(measurement), 테스트(test), 사용자 입력(user input)

### C. DOCUMENTS CONSIDERED TO BE RELEVANT

| Category* | Citation of document, with indication, where appropriate, of the relevant passages | Relevant to claim No. |
|---|---|---|
| A | KR 10-2020-0117794 A (LG CHEM, LTD.) 14 October 2020 (2020-10-14)<br>See paragraphs [0103]-[0104]; claim 3; and figures 1-2. | 1-14 |
| A | KR 10-2014-0066361 A (HYUNDAI MOBIS CO., LTD.) 02 June 2014 (2014-06-02)<br>See paragraphs [0018]-[0038]; and figures 1-2. | 1-14 |
| A | WO 2021-191216 A1 (LEEN CONSULTING AB) 30 September 2021 (2021-09-30)<br>See page 3, line 22 – page 16, line 22. | 1-14 |
| A | US 2017-0254859 A1 (BATTELLE ENERGY ALLIANCE, LLC) 07 September 2017 (2017-09-07)<br>See paragraphs [0027]-[0056]; and figures 2-4. | 1-14 |

☑ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **26 December 2024** | **31 December 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
|---|
| **PCT/KR2024/014884** |

| C. | DOCUMENTS CONSIDERED TO BE RELEVANT | |
|---|---|---|
| Category* | Citation of document, with indication, where appropriate, of the relevant passages | Relevant to claim No. |
| A | ZHU, J. G. et al. A new lithium-ion battery internal temperature on-line estimate method based on electrochemical impedance spectroscopy measurement. Journal of Power Sources. 274 (2015), 30 October 2014, pp. 990-1004.<br>[Retrieved on 05 December 2024]. Retrieved from <://sciencedirect.com/science/article/abs/pii/S0378775314018011>.<br>See pages 990-1003. | 1-14 |

Form PCT/ISA/210 (second sheet) (July 2022)

## INTERNATIONAL SEARCH REPORT
### Information on patent family members

International application No.

**PCT/KR2024/014884**

| Patent document cited in search report | | | Publication date (day/month/year) | Patent family member(s) | | | Publication date (day/month/year) |
|---|---|---|---|---|---|---|---|
| KR | 10-2020-0117794 | A | 14 October 2020 | CN | 112602226 | A | 02 April 2021 |
| | | | | CN | 112602226 | B | 06 February 2024 |
| | | | | EP | 3876334 | A1 | 08 September 2021 |
| | | | | EP | 3876334 | A4 | 19 January 2022 |
| | | | | JP | 2022-502815 | A | 11 January 2022 |
| | | | | JP | 7063440 | B2 | 09 May 2022 |
| | | | | US | 12123914 | B2 | 22 October 2024 |
| | | | | US | 2022-0221516 | A1 | 14 July 2022 |
| | | | | WO | 2020-204584 | A1 | 08 October 2020 |
| KR | 10-2014-0066361 | A | 02 June 2014 | CN | 103837833 | A | 04 June 2014 |
| | | | | CN | 103837833 | B | 03 May 2017 |
| WO | 2021-191216 | A1 | 30 September 2021 | CN | 115552263 | A | 30 December 2022 |
| | | | | EP | 4127751 | A1 | 08 February 2023 |
| | | | | JP | 2023-520996 | A | 23 May 2023 |
| | | | | KR | 10-2023-0003474 | A | 06 January 2023 |
| | | | | SE | 2050319 | A1 | 25 September 2021 |
| | | | | SE | 545121 | C2 | 04 April 2023 |
| | | | | US | 2023-0104336 | A1 | 06 April 2023 |
| US | 2017-0254859 | A1 | 07 September 2017 | CA | 3016537 | A1 | 08 September 2017 |
| | | | | CA | 3016537 | C | 20 July 2021 |
| | | | | CN | 109073713 | A | 21 December 2018 |
| | | | | CN | 109073713 | B | 10 August 2021 |
| | | | | EP | 3423850 | A1 | 09 January 2019 |
| | | | | EP | 3423850 | A4 | 13 November 2019 |
| | | | | EP | 3423850 | B1 | 21 December 2022 |
| | | | | JP | 2019-508697 | A | 28 March 2019 |
| | | | | JP | 6740363 | B2 | 12 August 2020 |
| | | | | KR | 10-2018-0122385 | A | 12 November 2018 |
| | | | | KR | 10-2082108 | B1 | 24 April 2020 |
| | | | | US | 10345384 | B2 | 09 July 2019 |
| | | | | WO | 2017-151955 | A1 | 08 September 2017 |

Form PCT/ISA/210 (patent family annex) (July 2022)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230139551